# NEUE EUROPÄISCHE PATENTSCHRIFT

(11) **EP 0 208 199 B2**
(45) Veröffentlichungstag und Bekanntmachung des Hinweises auf die Entscheidung über den Einspruch: **28.08.1996**
(45) Hinweis auf die Patenterteilung: 20.09.1989
(21) Anmeldenummer: 86108635.3
(22) Anmeldetag: 25.06.1986
(51) Int. Cl.: H03J 9/06

(54) **System zur Speicherung von Einstellwerten bei nachrichtentechnischen Geräten**
System for the storage of selected values for telecommunication apparatuses
Système d'emmagasinage de valeurs sélectionnées pour appareils de télécommunication

(30) Priorität: 09.07.1985 DE 3524455
(43) Veröffentlichungstag der Anmeldung: 14.01.1987
(73) Patentinhaber: Blaupunkt-Werke GmbH, D-31132 Hildesheim (DE)
(72) Erfinder: Baum, Wolfgang, Ing. grad., D-3200 Hildesheim (DE)
(74) Vertreter: Friedmann, Jürgen, Dr.-Ing.

(56) Entgegenhaltungen:
- DE-A- 2 856 042
- FR-A- 2 379 959
- ELEKTRONIK, Band 33, Nr. 4, Februar 1984, Seiten 53-56, München, DE; G. PELTZ: "Mikrocomputer steuert Fernbedienung und Abstimmung"
- Gebrauchsanweisung für das Farbfernsehgerät "Palladium 733"
- Rechnung Nr. 30 40 71 vom 02.01.84 von Salora
- Rechnung Nr. 30 40 82 vom 02.01.84 von Salora
- Rechnung Nr. 30 40 86 vom 03.01.84 von Salora
- Rechnung Nr. 30 41 00 vom 06.01.84 von Salora

## Beschreibung

Die Erfindung geht aus von einem System nach der Gattung des Hauptanspruchs.

Es sind bereits Einrichtungen bekannt geworden, bei welchen beispielsweise die Einstellung von Helligkeit, Kontrast, Farbsättigung und Farbton eines Farbfernsehempfängers durch einen einzigen Tastendruck auf eine Normaleinstellung zurückgeführt werden kann. Da die Signaleigenschaften von Sender zu Sender unterschiedlich sein können, kann es bei diesen bekannten Einrichtungen vorkommen, daß eine für einen Sender durchgeführte Normal- oder Grundeinstellung bei einem anderen Sender zu einer unbefriedigenden Einstellung führt.

Bei einer anderen bekannten Schaltungsanordnung (DE-A-28 04 296) werden daher individuelle Einstellwerte für die zu empfangenden Sender gespeichert. Diese Einstellwerte sind dann durch Betätigung des Kanalwählers abrufbar. Diese bekannten Einrichtungen haben den Nachteil, daß bei der Umschaltung von einem Sender auf einen anderen, wenn zuvor eine von der Normaleinstellung abweichende Einstellung gewählt wurde, diese Abweichung nicht auf den zweiten Sender übertragen wird. Hat beispielsweise der Benutzer eines Fernesehgerätes am späten Abend die Lautstärke gegenüber der Normaleinstellung beim Empfang eines ersten Senders reduziert, so wird bei der Umschaltung auf einen zweiten Sender die Lautstärke auf die für diesen Sender gespeicherte Normaleinstellung umgeschaltet, welche üblicherweise wesentlich größer als die vom Benutzer am späten Abend eingestellte Lautstärke ist.

Aus der Gebrauchsanweisung für Farbfernsehgeräte mit der Herstellerbezeichnung "Palladium", Artikel-Nr. 733/MMM, die nachweislich in der ersten Kalenderwoche 1984 in den Handel gelangte, ist unter der Überschrift "Individuelles Bild- und Toneinstellsystem" das folgende bekannt:
1. Beim Einschalten des Empfängers stellt sich Bild und Ton auf die im Werk eingestellten und gespeicherten Grundwerte ein. Diese Werte sind für alle Programmplätze gleich.
2. Sollten Sie jedoch für jeden Programmkanal wegen unterschiedlicher Signalquellen, wie Fernsehen, Videorecorder, usw. getrennte Bild- und Toneinstellungen einspeichern wollen, so ist das mit der individuellen Einstellung möglich. Es werden dann die Grundwerte des Programmplatzes 1 als Basis genommen, von denen bis zu einem bestimmten Wert abgewichen werden kann. Die darüber hinausgehende Abweichung wird nicht eingespeichert.
2.2:Wenn Sie vorübergehend die Einstellung ändern wollen, können Sie das mit den Plus- und Minustasten machen. Diese Einstellung ändert gleichzeitig die Einstellwerte aller Programmkanäle. Eine Rückkehr zu den individuellen Werten erreichen Sie mit der Taste N (Normierung), Die N-Taste beeinflußt nur die Bildeinstellung.

Es ist Aufgabe der vorliegenden Erfindung ein System anzugeben, welches dem Nutzer von nachrichtentechnischen Geräten bei Programmwechseln das Nachstellen der Einstellwerte komfortabel erspart, wobei der Schaltungsaufwand für das System, insbesondere im Hinblick auf den nötigen Speicherbedarf, gering gehalten werden soll.

Das erfindungsgemäße System mit den kennzeichnenden Merkmalen des Hauptanspruchs hat den Vorteil, daß von den Normaleinstellungen abweichende Einstellungen bei der Umschaltung von einem Sender auf einen anderen wirksam bleiben.

Durch die in den Unteransprüchen aufgeführten Maßnahmen sind vorteilhafte Weiterbildungen und Verbesserungen des im Hauptanspruch angegebenen Systems möglich.

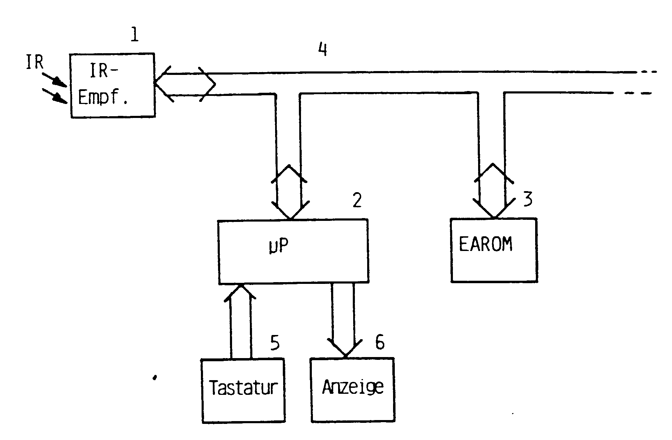

Ein Ausführungsbeispiel der Erfindung ist in der Zeichnung dargestellt und in der nachfolgenden Beschreibung näher erläutert

Das erfindungsgemäße System lächt sich mit den in der Zeichnung dargestellten an sich bekannten Komponenten in einfacher Weise verwirklichen. Ein für die Fembedienung vorgesehener Strahlungsempfänger 1, vorzugsweise ein Infrarotempfänger, ist über eine Busleitung mit einem Mikroprozessor 2 und einem nichtflüchtigen Speicher 3, vorzugsweise einem EAROM (electrically alternatable read-only memory), verbunden.

Femer sind an die Datenleitung 4 noch weitere nicht dargestellte Komponenten, wie beispielsweise ein digital ansteuerbarer Kanalschalter, angeschlossen. Der Mikroprozessor 2 ist außerdem mit einer Tastatur 5 und einer Anzeigevorrichtung 6 verbunden.

Bei der erstmaligen Inbetriebnahme des Gerätes beim Benutzer oder auch zu späteren Zeitpunkten wird nacheinander für die zu empfangenden Sender eine Normal- bzw. Grundeinstellung der Lautstärke, des Kontrasts, der Helligkeit, der Farbsättigung und des Farbtons vorgenommen. Je nach im Einzelfall zu vertretendem technischen Aufwand können weniger oder mehr als die genannten Werte in das erfindungsgemäße System einbezogen werden. Bei der Durchführung der Grundeinstellung werden für einen ersten Sender die erforderlichen Einstellungen vorgenommen und die erhaltenen Werte abgespeichert. Bei den folgenden Sendern wird ebenfalls die erforderliche Einstellung durchgeführt. Abgespeichert werden lediglich die Differenzen zur Grundeinstellung des ersten Senders. Sowohl die absoluten Werte für den ersten als auch die Differenzwerte für die weiteren Sender werden im nichtflüchtigen Speicher 4 abgelegt Neben dem bereits erwähnten EAROM, kann auch ein RAM (Schreib-Lese-Speicher) verwendet werden, welcher mit einer wiederaufladbaren Batterie gepuffert wird, um auch bei abgeschaltetem Fernsehgerät oder bei Ausfall der Netzspannung die einmal eingestellten Werte zu erhalten.

Wird beim Empfang der eingestellten Sender keine Abweichung von der obenbeschriebenen Grundeinstellung vorgenommen, so wird bei einer Umschaltung von einem auf einen anderen Sender die Grundeinstellung entsprechend geändert. Eine entsprechende Änderung erfolgt auch bei geänderten Einstellungen.

Ändert sich beispielsweise abends die Umfeldlautstärke, so wird der Benutzer die Lautstärkeeinstellung reduzieren. Dabei wird aus dem Speicher 4 zwar der für den ersten Sender eingestellte Normalwert abgerufen, jedoch entsprechend der jeweiligen erwünschten Einstellung verändert. Eine derartige Änderung kann außer aus Gründen des Umfeldes auch durch individuelle Wünsche verschiedener Benutzer bedingt sein. Wird nun bei einer solchen abweichenden Einstellung vom Empfang eines ersten auf den Empfang eines der weiteren Sender umgeschaltet, so werden zusätzlich zu den individuell veränderten Einstellwerten für den ersten Sender die für den weiteren Sender gespeicherten Differenzwerte wirksam und die eingestellte Größe, in diesem Fall also die Lautstärke, entsprechend verändert. Anstelle der Speicherung von Normal-Einstellwerten für den ersten Sender kann auch die Speicherung von nicht auf einen Sender bezogenen Vergleichs-Einstellwerten vorgenommen werden. In diesem Fall werden auch für den ersten Sender Differenzwerte gespeichert.

## Patentansprüche

1. System zur Speicherung von Einstellwerten bei nachrichtentechnischen Geräten, insbesondere bei Fernseh-Empfangsgeräten, wobei die Einstellwerte abrufbare Normaleinstellungen für verschiedene mit Hilfe eines progammspeichers einstellbare Sender darstellen, wobei für verschiedene Sender verschiedene Einstellwerte eingebbar und abspeicherbar sind, dadurch gekennzeichnet,
a) daß für einen bestimmten ersten Sender Einstellwerte gespeichert werden und die Einstellwerte für die anderen Sender als Differenz der Werte zu den Einstellwerten des ersten Senders gespeichert werden,
oder,
die Einstellwerte für alle Sender als Differenz der Werte zu nicht auf einen bestimmten Sender bezogenen Vergleichseinstellwerten gespeichert werden,
b) daß bei der Anwahl eines Senders die auf den ersten Sender bezogenen Einstellwerte oder die Vergleichseinstellwerte und die auf den ausgewählten Sender bezogenen Differenzwerte aus einem Speicher (3) abgerufen und gemeinsam wirksam werden, und
c) daß Mittel zur von der Normaleinstellung abweichenden Einstellung vorgesehen sind, welche auf die aus dem Speicher (3) abgerufenen und auf den ersten Sender bezogenen Einstellwerte oder auf die Vergleichseinstellwerte einwirken.

2. System nach Anspruch 1, dadurch gekennzeichnet, daß die Einstellwerte eine oder mehrere von folgenden Größen betreffen: Lautstärke, Kontrast, Helligkeit, Farbsättigung und Farbton.

3. System nach Anspruch 1, dadurch gekennzeichnet, daß ein der Fernbedienung dienender Strahlungsempfänger (1) über eine Busleitung (4) mit einem Mikroprozessor (2) und mit einem nichtflüchtigen Speicher (3) verbunden ist.

## Claims

1. System for the storage of setting values for communication equipment, in particular for television receiver sets, the setting values representing normal settings, which can be called up, for various stations which can be set with the aid of a program memory, it being possible for different setting values to be entered and stored for different stations, characterized
a) in that setting values are stored for a specific first station and the setting values for the other stations are stored as the difference of the values from the setting values of the first station,
or,
the setting values for all the stations are stored as the difference of the values from comparison setting values not related to a specific station,
b) in that, in the selection of a station, the setting values related to the first station or the comparison setting values and the difference values related to the selected station are called up from a memory (3) and become effective together, and
c) in that means for setting other than the normal setting are provided, which act on the setting values called up from the memory (3) and related to the first station or on the comparison setting values.

2. System according to Claim 1, characterized in that the setting values relate to one or more of the following parameters: volume, contrast, brightness, chromaticity.

3. System according to Claim 1, characterized in that a radiation receiver (1) serving for remote control is connected by a bus line (4) to a microprocessor (2) and to a non-volatile memory (3).

## Revendications

1. Système de mise en mémoire de valeurs de réglages par appareils de communication, en particulier pour des appareils récepteurs de télévision, les valeurs de réglage représentant des réglages normaux interrogeables de différents émetteurs réglables à l'aide d'une mémoire à programme, caractérisé en ce que des valeurs de réglage différentes associées aux différents émetteurs pouvant être introduites et mémorisées, caractérisé en ce que :
a) pour un premier émetteur, déterminé, on mémorise des valeurs de réglage et ces valeurs de réglage pour les autres émetteurs sont mémorisées sous la forme de la différence des valeurs par rapport aux valeurs de réglage du premier émetteur,
ou
les valeurs de réglage de tous les émetteurs sont prises comme la différence des valeurs par rapport à des valeurs de réglage de comparaison non liées à un émetteur déterminé,
b) lors de la sélection d'un émetteur on appelle les valeurs de réglage rapportées au premier émetteur ou les valeurs de réglage de comparaison ainsi que les valeurs des différences rapportées à l'émetteur sélectionné dans une mémoire (3) et ces valeurs sont mises en oeuvre en commun ; et
c) on prévoit des moyens pour régler différemment du réglage normal, ces moyens agissant sur les valeurs de réglage appelées dans la mémoire (3) et qui agissent sur les valeurs de réglage rapportées au premier émetteur ou sur les valeurs de réglage de comparaison.

2. Système selon la revendication 1, caractérisé en ce que les valeurs de réglage peuvent concerner une ou plusieurs des grandeurs suivantes : intensité du son, contraste, luminosité, saturation des couleurs de nuances.

3. Système selon la revendication 1, caractérisé en ce qu'un émetteur à rayonnement (1) servant à la manoeuvre à distance est relié, par l'intermédiaire d'une ligne de bus (4), à un microprocesseur (2) et à une mémoire rémanente (3).
